# EUROPEAN PATENT APPLICATION

(11) **EP 4 819 554 A1**
(43) Date of publication of application: **07.10.2026**
(21) Application number: 26167673.8
(22) Date of filing: 25.03.2026
(51) Int. Cl.: H04L 25/03

(54) **EFFICIENT DUAL SPHERE SOFT DEMAPPING FOR MULTI ANTENNA COMMUNICATION SYSTEMS**

(30) Priority: 31.03.2025 US 202563780813 P; 23.09.2025 US 202519336858
(71) Applicant: Avago Technologies International Sales Pte. Limited, Singapore 768923 (SG)
(72) Inventor: Pulikkoonattu, Rethnakaran, Irvine, 92618 (US)
(74) Representative: Dilg, Haeusler, Schindelmann Patentanwaltsgesellschaft mbH

(57) **Abstract**

In some implementations, a wireless device may include one or more processors. The one or more processors may be configured to perform first soft demapping using sphere decoding on first data relating to a first stream and a second stream among a plurality of spatial streams. The one or more processors may be configured to perform second soft demapping using sphere decoding on second data relating to the first stream and the second stream, different from the first data. The one or more processors may be configured to determine, using a result of the first soft decoding and a result of the second soft decoding, log likelihood ratio (LLR) values of the first stream and the second stream.

## Description

### Field of the Disclosure

This disclosure generally relates to systems and methods for soft demapping using sphere decoding in multiple input multiple output (MIMO) systems.

### Background of the Disclosure

The process of demapping in digital communication systems, particularly those utilizing high-order Quadrature Amplitude Modulation (QAM), is inherently computationally intensive due to the exhaustive search executed over the constellation grid. As modulation order increases (e.g., 64-QAM, 256-QAM), the number of possible symbol candidates grows exponentially, resulting in a dense inner grid that must be evaluated to determine the most likely transmitted symbol. This inner grid search becomes a bottleneck in real-time systems, especially when computing soft information such as log-likelihood ratios (LLRs) for each bit.

### Brief Description of the Drawings

Various objects, aspects, features, and advantages of the disclosure will become more apparent and better understood by referring to the detailed description taken in conjunction with the accompanying drawings, in which like reference characters identify corresponding elements throughout. In the drawings, like reference numbers generally indicate identical, functionally similar, and/or structurally similar elements.
FIG. 1A is a block diagram depicting a network environment including one or more access points in communication with one or more devices or stations, according to some embodiments.
FIGS. 1B and 1C are block diagrams depicting computing devices useful in connection with the methods and systems described herein, according to some embodiments.
FIG. 2 is a block diagram of a MIMO mapping and demapping system.
FIGS. 3A-3B are channel matrix permutations, according to one or more embodiments.
FIG. 4 is a sphere demapping graph, according to one or more embodiments.
FIGS 5A-5B are histograms representing computational resources used for sphere demapping, according to one or more embodiments.
FIG. 6 is a flowchart showing a process for efficient dual sphere soft demapping for multi antenna communication systems, according to one or more embodiments.

The details of various embodiments of the methods and systems are set forth in the accompanying drawings and the description below.

### Detailed Description

The following disclosure provides many different embodiments, or examples, for implementing different features of the provided subject matter. Specific examples of components and arrangements are described below to simplify the present disclosure. These are, of course, merely examples and are not intended to be limiting. For example, a first feature in communication with or communicatively coupled to a second feature in the description that follows may include embodiments in which the first feature is in direct communication with or directly coupled to the second feature and may also include embodiments in which additional features may intervene between the first and second features, such that the first feature is in indirect communication with or indirectly coupled to the second feature. In addition, the present disclosure may repeat reference numerals and/or letters in the various examples. This repetition is for the purpose of simplicity and clarity and does not in itself dictate a relationship between the various embodiments and/or configurations discussed.

Various embodiments disclosed herein relate to a wireless device comprising one or more processors. The one or more processors may be configured to perform first soft demapping using sphere decoding on first data relating to a first stream and a second stream among a plurality of spatial streams. The one or more processors may be configured to perform second soft demapping using sphere decoding on second data relating to the first stream and the second stream, different from the first data. The one or more processors may be configured to determine, using a result of the first soft demapping and a result of the second soft demapping, log likelihood ratio (LLR) values of the first stream and the second stream.

In some implementations, the first stream and the second stream have different modulation sizes.

In some implementations, the first data includes a first matrix and the second data includes a second matrix, and the one or more processors are configured to generate the second matrix by permuting the first matrix.

In some implementations, in performing the first soft demapping, the one or more processors are configured to perform a sphere search on the first stream using the first data to determine LLR values of the first stream, and in performing the second soft demapping, the one or more processors are configured to perform a sphere search on the second stream using the second data to determine LLR values of the second stream.

In some implementations, the wireless device further comprises a receiver configured to receive encoded data from another wireless device over a communication channel. The one or more processors may receive a set of symbols from the plurality of spatial streams of the encoded data including the first stream and the second stream. The one or more processors may determine, using the sphere decoding on the first data, first normalized signal values associated with the set of symbols from the first stream. The one or more processors may determine first LLR values of the first stream using the first normalized signal values.

In some implementations, the one or more processors may be further configured to generate a look-up table (LUT) including one or more slicing errors of the first normalized signal values. In some implementations, the first LLR values are determined using the LUT.

In some implementations, the one or more processors may be further configured to determine, using the sphere decoding on the second data, second normalized signal values associated with the set of symbols from the second stream; and determine second LLR values of the second stream using the second normalized signal values.

In some implementations, the one or more processors may be configured to perform a first QR decomposition on a first matrix relating to a first stream and a second stream among a plurality of spatial streams. The one or more processors may be configured to perform a second QR decomposition on a second matrix relating to the first stream and the second stream, different from the first matrix. The one or more processors may be configured to perform, using a result of the first QR decomposition and a result of the second QR decomposition, soft demapping using sphere decoding on the first stream and the second stream.

Embodiments of the present disclosure can provide systems and methods for demapping in MIMO systems using LUT-based sphere demapping for a plurality of streams. For example, a transmitter in a MIMO system may include a plurality of transmit antennas that transmit a plurality of streams to a receiver in the MIMO system that includes a plurality of receiving antennas. In some examples, sphere demapping with a lookup table (LUT) may be used to demap a first stream while QAM inner grid search may be used to demap a second stream. Sphere demapping may involve searching within a constrained hypersphere around the received signal to reduce complexity, while QAM inner grid search may involve exhaustively evaluating all constellation points to ensure precise symbol detection. Sphere demapping can also use a LUT to further reduce complexity of sphere demapping by precomputing and storing symbol-to-bit mappings, allowing fast retrieval during demapping instead of recalculating distances or likelihoods for each received symbol. This hybrid approach can allow the system to exploit the lower complexity of LUT-based sphere demapping while reserving the more computationally intensive grid search for other streams. However, in this approach, the QAM inner grid search may be significantly more computationally expensive than the sphere demapping, especially for higher modulation orders. Since higher modulation orders exponentially increase constellation points, executing QAM inner grid search for these higher modulation order decoding schemes involves intensive computations that strain latency and power efficiency in real-time systems.

The present disclosure provides systems and methods for demapping both streams using LUT-based sphere demapping. A channel matrix may be a representation of a plurality of signals received from plurality of antennas in a MIMO system. To execute sphere demapping for a first stream, QR decomposition may be applied to the channel matrix. The present disclosure provides systems and methods for permutating the channel matrix and applying an additional QR decomposition so that LUT-based sphere demapping may also be used to demap the second stream. By applying the permutation, the LUT table used to demap the first stream may also be used to demap the second stream. Since the complexity of sphere-based demapping using the LUT table is fixed (e.g., based on the number of constellation points in the sphere) and the complexity of QAM inner grid search scales with modulation order, switching from inner grid search to LUT-based sphere-based demapping for the second stream using the same LUT table used to demap the first stream can significantly reduce the complexity of demapping (e.g., and therefore the computational resources used), particularly for streams with high modulation orders.

The following IEEE standard(s), including any draft versions of such standard(s), are hereby incorporated herein by reference in their entirety and are made part of the present disclosure for all purposes: WiFi Alliance standards and IEEE 802.11 standards including but not limited to IEEE 802.11a^{™}, IEEE 802.11b^{™}, IEEE 802.11g^{™}, IEEE P802.11n^{™}; IEEE P802.11ac^{™}; and IEEE P802.11be^{™} through IEEE P802.11bn^{™} standards. Although this disclosure can reference aspects of these standard(s), the disclosure is in no way limited by these standard(s).

For purposes of reading the description of the various embodiments below, the following descriptions of the sections of the specification and their respective contents can be helpful:
- Section A describes a network environment and computing environment which can be useful for practicing embodiments described herein; and
- Section B describes embodiments of efficient dual sphere soft demapping for MIMO communication systems.

### A. Computing and Network Environment

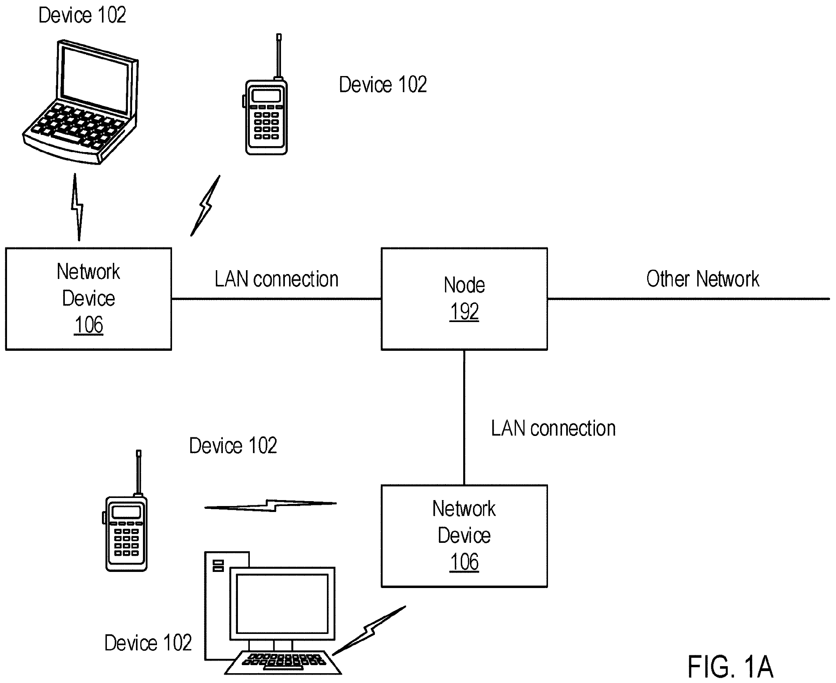

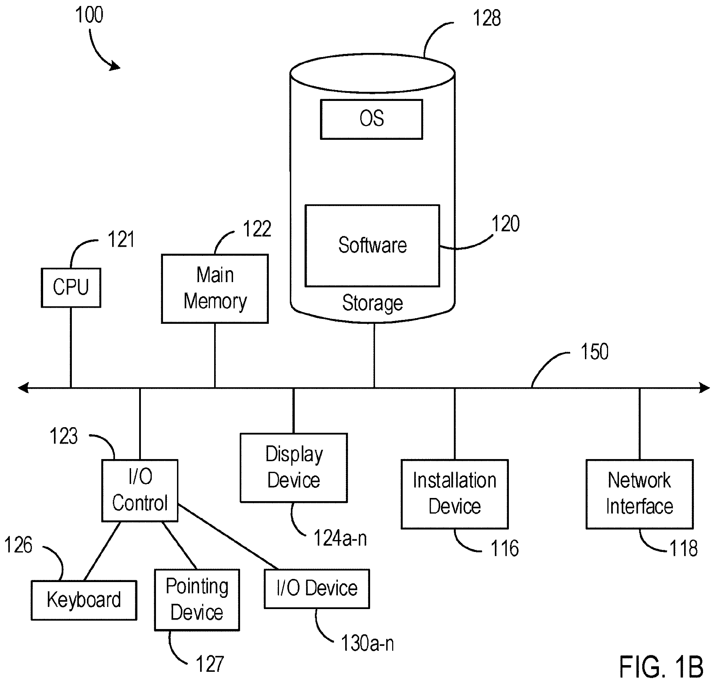

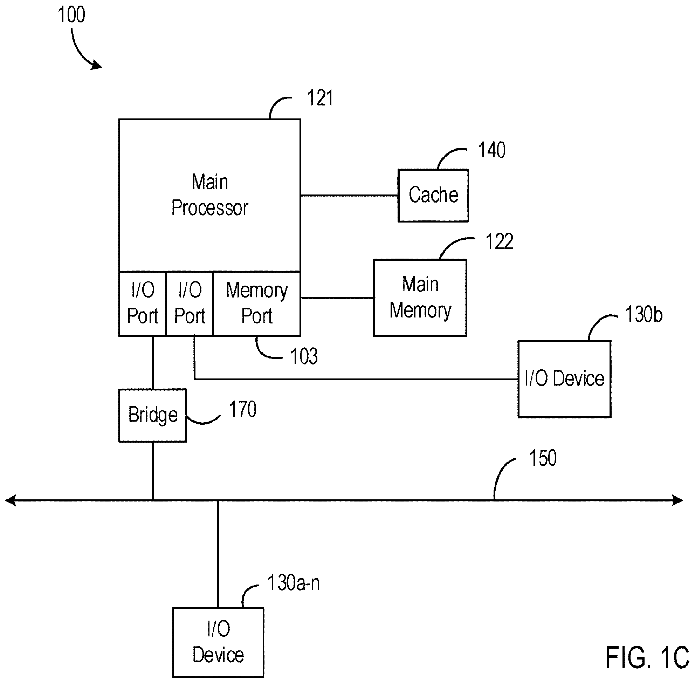

Prior to discussing specific embodiments of the present solution, it can be helpful to describe aspects of the operating environment as well as associated system components (e.g., hardware elements) in connection with the methods and systems described herein. Referring to FIG. 1A, an embodiment of a network environment is depicted. In brief overview, the network environment includes a wireless communication system that includes one or more access points (APs) or network devices 106, one or more stations or wireless communication devices 102 and a network hardware component or network hardware 192. The wireless communication devices 102 can for example include laptop computers, tablets, personal computers, and/or cellular telephone devices. The details of an embodiment of each station or wireless communication device 102 and AP or network device 106 are described in greater detail with reference to FIGS. 1B and 1C. The network environment can be an ad hoc network environment, an infrastructure wireless network environment, a subnet environment, etc. in one embodiment. The network devices 106 or APs can be operably coupled to the network hardware 192 via local area network connections. Network devices 106 are 5G base stations in some embodiments. The network hardware 192, which can include a router, gateway, switch, bridge, modem, system controller, appliance, etc., can provide a local area network connection for the communication system. Each of the network devices 106 or APs can have an associated antenna or an antenna array to communicate with the wireless communication devices in its area. The wireless communication devices 102 can register with a particular network device 106 or AP to receive services from the communication system (e.g., via a SU-MIMO or MU-MIMO configuration). For direct connections (e.g., point-to-point communications), some wireless communication devices can communicate directly via an allocated channel and communications protocol. Some of the wireless communication devices 102 can be mobile or relatively static with respect to network device 106 or AP.

In some embodiments, a network device 106 or AP includes a device or module (including a combination of hardware and software) that allows wireless communication devices 102 to connect to a wired network using wireless-fidelity (WiFi), or other standards. A network device 106 or AP can sometimes be referred to as a wireless access point (WAP). A network device 106 or AP can be implemented (e.g., configured, designed and/or built) for operating in a wireless local area network (WLAN). A network device 106 or AP can connect to a router (e.g., via a wired network) as a standalone device in some embodiments. In other embodiments, network device 106 or AP can be a component of a router. Network device 106 or AP can provide multiple devices access to a network. Network device 106 or AP can, for example, connect to a wired Ethernet connection and provide wireless connections using radio frequency links for other devices 102 to utilize that wired connection. A network device 106 or AP can be implemented to support a standard for sending and receiving data using one or more radio frequencies. Those standards, and the frequencies they use can be defined by the IEEE (e.g., IEEE 802.11 standards). A network device 106 or AP can be configured and/or used to support public Internet hotspots, and/or on a network to extend the network's Wi-Fi signal range.

In some embodiments, the access points or network devices 106 can be used for (e.g., in-home, in-vehicle, or in-building) wireless networks (e.g., IEEE 802.11, Bluetooth, ZigBee, any other type of radio frequency based network protocol and/or variations thereof). Each of the wireless communication devices 102 can include a built-in radio and/or is coupled to a radio. Such wireless communication devices 102 and /or access points or network devices 106 can operate in accordance with the various aspects of the disclosure as presented herein to enhance performance, reduce costs and/or size, and/or enhance broadband applications. Each wireless communication device 102 can have the capacity to function as a client node seeking access to resources (e.g., data, and connection to networked nodes such as servers) via one or more access points or network devices 106.

The network connections can include any type and/or form of network and can include any of the following: a point-to-point network, a broadcast network, a telecommunications network, a data communication network, a computer network. The topology of the network can be a bus, star, or ring network topology. The network can be of any such network topology as known to those ordinarily skilled in the art capable of supporting the operations described herein. In some embodiments, different types of data can be transmitted via different protocols. In other embodiments, the same types of data can be transmitted via different protocols.

The communications device(s) 102 and access point(s) or network devices 106 can be deployed as and/or executed on any type and form of computing device, such as a computer, network device or appliance capable of communicating on any type and form of network and performing the operations described herein. FIGS. 1B and 1C depict block diagrams of a computing device 100 useful for practicing an embodiment of the wireless communication devices 102 or network device 106. As shown in FIGS. 1B and 1C, each computing device 100 includes a processor 121 (e.g., central processing unit), and a main memory unit 122. As shown in FIG. 1B, a computing device 100 can include a storage device 128, an installation device 116, a network interface 118, an I/O controller 123, display devices 124a-124n, a keyboard 126 and a pointing device 127, such as a mouse. The storage device 128 can include an operating system and/or software. As shown in FIG. 1C, each computing device 100 can also include additional optional elements, such as a memory port 103, a bridge 170, one or more input/output devices 130a-130n, and a cache memory 140 in communication with the central processing unit or processor 121.

The central processing unit or processor 121 is any logic circuitry that responds to and processes instructions fetched from the main memory unit 122. In many embodiments, the central processing unit or processor 121 is provided by a microprocessor unit, such as: those manufactured by Intel Corporation of Santa Clara, California; those manufactured by International Business Machines of White Plains, New York; or those manufactured by Advanced Micro Devices of Sunnyvale, California. The computing device 100 can be based on any of these processors, or any other processor capable of operating as described herein.

Main memory unit 122 can be one or more memory chips capable of storing data and allowing any storage location to be directly accessed by the microprocessor or processor 121, such as any type or variant of Static random access memory (SRAM), Dynamic random access memory (DRAM), Ferroelectric RAM (FRAM), NAND Flash, NOR Flash and Solid State Drives (SSD). The main memory unit 122 can be based on any of the above-described memory chips, or any other available memory chips capable of operating as described herein. In the embodiment shown in FIG. 1B, the processor 121 communicates with main memory unit 122 via a system bus 150 (described in more detail below). FIG. 1C depicts an embodiment of a computing device 100 in which the processor communicates directly with main memory unit 122 via a memory port 103. For example, in FIG. 1C the main memory unit 122 can be DRDRAM.

FIG. 1C depicts an embodiment in which the main processor 121 communicates directly with cache memory 140 via a secondary bus, sometimes referred to as a backside bus. In other embodiments, the main processor 121 communicates with cache memory 140 using the system bus 150. Cache memory 140 typically has a faster response time than main memory unit 122 and is provided by, for example, SRAM, BSRAM, or EDRAM. In the embodiment shown in FIG. 1C, the processor 121 communicates with various I/O devices 130 via a local system bus 150. Various buses can be used to connect the central processing unit or processor 121 to any of the I/O devices 130, for example, a VESA VL bus, an ISA bus, an EISA bus, a Micro Channel Architecture (MCA) bus, a PCI bus, a PCI-X bus, a PCI-Express bus, or a NuBus. For embodiments in which the I/O device is a video display 124, the processor 121 can use an Advanced Graphics Port (AGP) to communicate with the display 124. FIG. 1C depicts an embodiment of a computer or computer system100 in which the main processor 121 can communicate directly with I/O device 130b, for example via HYPERTRANSPORT, RAPIDIO, or INFINIBAND communications technology. FIG. 1C also depicts an embodiment in which local busses and direct communication are mixed: the processor 121 communicates with I/O device 130a using a local interconnect bus while communicating with I/O device 130b directly.

A wide variety of I/O devices 130a-130n can be present in the computing device 100. Input devices include keyboards, mice, track pads, trackballs, microphones, dials, touch pads, touch screen, and drawing tablets. Output devices include video displays, speakers, inkjet printers, laser printers, projectors and dye-sublimation printers. The I/O devices can be controlled by an I/O controller 123 as shown in FIG. 1B. The I/O controller can control one or more I/O devices such as a keyboard 126 and a pointing device 127, e.g., a mouse or optical pen. Furthermore, an I/O device can also provide storage and/or an installation medium for the computing device 100. In still other embodiments, the computing device 100 can provide USB connections (not shown) to receive handheld USB storage devices such as the USB Flash Drive line of devices manufactured by Twintech Industry, Inc. of Los Alamitos, California.

Referring again to FIG. 1B, the computing device 100 can support any suitable installation device 116, such as a disk drive, a CD-ROM drive, a CD-R/RW drive, a DVD-ROM drive, a flash memory drive, tape drives of various formats, USB device, hard-drive, a network interface, or any other device suitable for installing software and programs. The computing device 100 can further include a storage device, such as one or more hard disk drives or redundant arrays of independent disks, for storing an operating system and other related software, and for storing application software programs such as any program or software 120 for implementing (e.g., configured and/or designed for) the systems and methods described herein. Optionally, any of the installation devices 116 could also be used as the storage device. Additionally, the operating system and the software can be run from a bootable medium.

Furthermore, the computing device 100 can include a network interface 118 to interface to a network through a variety of connections including, but not limited to, standard telephone lines, LAN or WAN links (e.g., 802.11, T1, T3, 56kb, X.25, SNA, DECNET), broadband connections (e.g., ISDN, Frame Relay, ATM, Gigabit Ethernet, Ethernet-over-SONET), wireless connections, or some combination of any or all of the above. Connections can be established using a variety of communication protocols (e.g., TCP/IP, IPX, SPX, NetBIOS, Ethernet, ARCNET, SONET, SDH, Fiber Distributed Data Interface (FDDI), RS232, IEEE 802.11, IEEE 802.11a, IEEE 802.11b, IEEE 802.11g, IEEE 802.11n, IEEE 802.11ac, IEEE 802.11ad, CDMA, GSM, WiMax and direct asynchronous connections). In one embodiment, the computing device 100 communicates with other computing devices 100' via any type and/or form of gateway or tunneling protocol such as Secure Socket Layer (SSL) or Transport Layer Security (TLS). The network interface 118 can include a built-in network adapter, network interface card, PCMCIA network card, card bus network adapter, wireless network adapter, USB network adapter, modem or any other device suitable for interfacing the computing device 100 to any type of network capable of communication and performing the operations described herein.

In some embodiments, the computing device 100 can include or be connected to one or more display devices 124a-124n. As such, any of the I/O devices 130a-130n and/or the I/O controller 123 can include any type and/or form of suitable hardware, software, or combination of hardware and software to support, enable or provide for the connection and use of the display device(s) 124a-124n by the computing device 100. For example, the computing device 100 can include any type and/or form of video adapter, video card, driver, and/or library to interface, communicate, connect or otherwise use the display device(s) 124a-124n. In one embodiment, a video adapter can include multiple connectors to interface to the display device(s) 124a-124n. In other embodiments, the computing device 100 can include multiple video adapters, with each video adapter connected to the display device(s) 124a-124n. In some embodiments, any portion of the operating system of the computing device 100 can be configured for using multiple display devices 124a-124n. In further embodiments, an I/O device 130 can be a bridge between the system bus 150 and an external communication bus, such as a USB bus, an Apple Desktop Bus, an RS-232 serial connection, a SCSI bus, a FireWire bus, a FireWire 800 bus, an Ethernet bus, an AppleTalk bus, a Gigabit Ethernet bus, an Asynchronous Transfer Mode bus, a Fibre Channel bus, a fiber optic bus, a Serial Attached small computer system interface bus, a USB connection, or a HDMI bus.

A computing device 100 of the sort depicted in FIGS. 1B and 1C can operate under the control of an operating system, which controls scheduling of tasks and access to system resources. The computing device 100 can be running any operating system such as any of the versions of the MICROSOFT WINDOWS operating systems, the different releases of the Unix and Linux operating systems, any version of the MAC OS for Macintosh computers, any embedded operating system, any real-time operating system, any open source operating system, any proprietary operating system, any operating systems for mobile computing devices, or any other operating system capable of running on the computing device and performing the operations described herein. Typical operating systems include, but are not limited to: Android, produced by Google Inc.; WINDOWS 7, 8 and 10, produced by Microsoft Corporation of Redmond, Washington; MAC OS, produced by Apple Computer of Cupertino, California; WebOS, produced by Research In Motion (RIM); OS/2, produced by International Business Machines of Armonk, New York; and Linux, a freely-available operating system distributed by Caldera Corp. of Salt Lake City, Utah, or any type and/or form of a Unix operating system, among others.

The computer system or computing device 100 can be any workstation, telephone, desktop computer, laptop or notebook computer, server, handheld computer, mobile telephone or other portable telecommunications device, media playing device, a gaming system, mobile computing device, or any other type and/or form of computing, telecommunications or media device that is capable of communication. In some embodiments, the computing device 100 can have different processors, operating systems, and input devices consistent with the device. For example, in one embodiment, the computing device 100 is a smart phone, mobile device, tablet or personal digital assistant. Moreover, the computing device 100 can be any workstation, desktop computer, laptop or notebook computer, server, handheld computer, mobile telephone, any other computer, or other form of computing or telecommunications device that is capable of communication and that has sufficient processor power and memory capacity to perform the operations described herein.

Aspects of the operating environments and components described above will become apparent in the context of the systems and methods disclosed herein.

### B. EFFICIENT DUAL SPHERE SOFT DEMAPPING FOR MIMO COMMUNICATION SYSTEMS

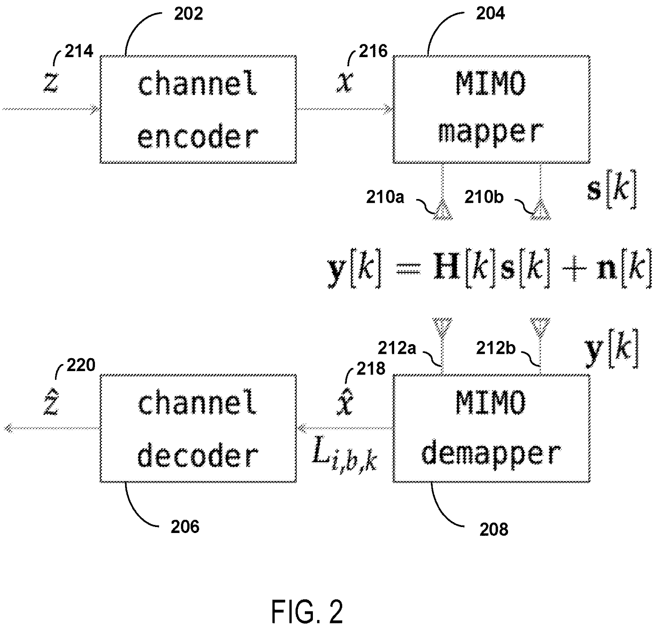

FIG. 2 is a block diagram of a MIMO mapping and demapping system. For example, a transmitter of a MIMO system including channel encoder 202 and MIMO mapper 204 may encode input data 214 to generate encoded data 216. Using transmitter antennas 210a and 210b, the transmitter may transmit the encoded data 216 to a receiver of the MIMO system including MIMO demapper 208 and channel decoder 206. MIMO demapper can map a received signal to demapped encoded data 218. The demapped encoded data 218 can then be decoded to generate decoded data 220.

In some implementations, input data 214 may be encoded by channel encoder 202. For example, channel encoder 202 may transform input data 214 into a coded format that enhances the confidentiality of the information during transmission, reduces errors in demapping data, and/or improves transmission efficiency by representing the input data 214 with a more compact message. Input data 214 can be encoded according to various schemes, such as convolutional coding, low-density parity-check (LDPC) coding, and/or the like. After encoded data 216 has been mapped and demapped as part of the transmission process, channel decoder 206 can decode demapped encoded data 218 according to the scheme it was encoded by to generate decoded data 220. In a case with no mapping or decoding errors, encoded data 216 and decoded data 220 may represent the same information.

In some implementations, MIMO mapper 204 may map encoded data 216 onto multiple spatial streams. As an example, as part of modulating encoded data 216 into a waveform for transmission (e.g., "s[k]"), MIMO mapper 204 may map encoded data 216 onto a first spatial stream associated with antenna 210a and a second spatial stream associated with antenna 210b. The two spatial streams may represent independently modulated data paths. Splitting encoded data 216 between the two spatial streams may allow the transmitter to transmit more data simultaneously, which can reduce transmission latency. In some examples, MIMO mapper 204 may modulate encoded data 216 according to different modulation schemes with different modulation sizes for antennas 210a and 210b. For example, two different quadrature amplitude modulation (QAM) schemes may be used. As an example, one antenna may transmit data modulated with a 256-QAM scheme associated with a constellation that has 256 constellation points (e.g., modulation size of 256) and the other may transmit data modulated with a 64-QAM scheme associated with a constellation that has 64 constellation points.

In some implementations, MIMO demapper 208 may receive a waveform signal transmitted by MIMO mapper 204. For example, MIMO demapper may receive a waveform signal (e.g., "y[k]") equal to the transmitted signal (e.g., "s[k]") multiplied by the gain of the respective antenna (e.g., "H[k]") with random noise (e.g., "n[k]"). Each of antenna 210a and 210b may have a different gain. In an example, the gain of the antenna may be a characteristic of the communication channel associated with the antenna. In an example, antenna 212a may be configured to receive a waveform signal from antenna 210a representing a portion of encoded data 216 and antenna 212b may be configured to receive a waveform signal from antenna 210b representing a separate portion of encoded data 216. These transmissions may represent two spatial streams (e.g., a first between antenna 210a and 212a and a second between antenna 210b and 212b).

In some implementations, MIMO demapper 208 may map the waveform signal received from MIMO mapper 204 to a set of constellation points associated with the modulation schemes of the first and second spatial streams. For example, MIMO demapper 208 may calculate LLR values indicating a probability that a received portion of the waveform represents a 0 or a 1. In some examples, the MIMO demapper 208 may perform QR decomposition before calculating LLR values. The MIMO demapper 208 may perform QR decomposition on a received signal to simplify the detection process by transforming the channel matrix into a form that facilitates efficient computation of likelihood ratios. "Y" may represent a received signal matrix based on a channel matrix "H" (e.g., gain and phase effects), a transmitted signal vector "S", and a noise vector "u." In this example, MIMO demapper 208 may perform QR decomposition using unitary matrix "Q" and upper triangular matrix "R." $\begin{matrix}Y = HS + u \\ {{=}^{︷}}^{{QQ}^{H} = I} QRS + u \\ {{{Q}^{H} Y}_{︸}}_{≜ {Y}^{˜}} = RS + {{{Q}^{H} u}_{︸}}_{= {u}^{˜}} \\ {Y}^{˜} = RS + {u}^{˜}\end{matrix}$ Equation 1: qr decomposition

The QR decomposition may simplify LLR calculations. For example, the demapper can exploit the triangular structure of "R" to perform efficient back-substitution, which can simplify the LLR calculations. In an example, LLR values may be generated according to the equations below. $\begin{matrix}{L}_{i , b}^{det} = log \frac{P \left({x}_{i , b}=\left.0\right|{y}^{˜},R\right)}{P \left({x}_{i , b}=\left.1\right|y,R\right)} \\ {{=}^{︷}}^{\left(Bayes\right)} log {\sum }_{s ∈ {X}_{i , b}^{0}} p \left(\left.{y}^{˜}\right|s,R\right) P \left(s\right) - log {\sum }_{s ∈ {X}_{i , b}^{1}} p \left(\left.{y}^{˜}\right|s,R\right) P \left(s\right) \\ {{\approx }^{︷}}^{max - log} {min}_{s ∈ {X}_{i , b}^{1}} {{\left\{\frac{1}{{N}_{0}}{\left‖{y}^{˜}-Rs\right‖}^{2}-logP\left(s\right)\right\}}_{︸}}_{≜ d \left(s\right)} - {min}_{s ∈ {X}_{i , b}^{0}} \left\{\frac{1}{{N}_{0}}{\left‖{y}^{˜}-Rs\right‖}^{2}-logP\left(s\right)\right\}\end{matrix}$ Equation 2: llr value generation In Equation 2, *"* ${L}_{i , b}^{det}$*"* may represent an LLR value for the bit "b" of symbol "i." MIMO demapper 208 can use the "max-log" approximation to determine the set of LLR values based on the *ỹ* generated from QR decomposition. This may be less computationally expensive than computing a full Maximum A Posteriori (MAP) expression (e.g., using the "Bayes" equation shown in Equation 2). The "max-log" approximation may be referred to as the Jacobian logarithm expansion, and can generally map ln(exp(a)+exp(b)) = max(a,b) + ln(1+exp(-|a-b|)) for a given "a" and "b." This approximation can simplify the computation of the full MAP expression function by approximating log-sum-exp operations with minimum and/or maximum operations, which can significantly reduce computational resources used to evaluate LLR values while maintaining an acceptable level of accuracy.

In some implementations, MIMO demapper 208 may use sphere decoding to demap received signals. The term sphere decoding may refer to decoding using sphere mapping, or any search-based demapping technique that restricts the candidate symbol vectors to those lying within a hypersphere centered around an initial estimate. The term sphere mapping may refer to any geometric constraint process of projecting candidate symbol vectors onto a hypersphere centered around an initial estimate. For example, MIMO demapper 208 may generate a center (e.g., based on a stream) and a predefined number of points around the stream. MIMO demapper 208 can then evaluate the Euclidean distances between the received signal and each candidate point within the sphere to compute soft metrics, such as LLR values, for each bit position.

In some implementations, MIMO demapper 208 may use a lookup table (LUT) as part of sphere decoding. This may consume less network resources than sphere mapping, but may be less accurate. The lookup table can include slicing errors. Slicing errors may represent the difference between an actual received signal and a nearest constellation point. In an example, normalized signals (e.g., *Ŝ*₁ when the flag flip value is set to 0) may be categorized into an LLR value based on which slice they fall into within the LUT. MIMO demapper 208 may store slicing errors associated with typical values that can be received in the LUT. MIMO demapper 208 may then retrieve the precomputed error values when generating LLR values to reduce real-time computational load. In an example, the LUT may account for normalization factors (e.g., K) and/or channel scaling (e.g., derived from QR decomposition). In an example, there may be separate LUTs may be specific to a certain stream. For example, LUTs may be optimized for a particular modulation order or channel condition associated with the stream.

In some implementations, sphere decoding can be selectively applied to some streams. As an example, equation 3 can represent sphere demapping using a 49-sphere demapping for a first stream (e.g., Li=1) and a 2 x M/2 QAM inner grid search for a second stream (e.g., Li=2). Sphere demapping may refer to using sphere decoding to efficiently identify transmitted symbols in complex modulation schemes, while QAM inner grid search may refer to refining symbol estimates by searching within the inner points of a QAM constellation. The complexity of sphere demapping may be a fixed value based on the number of points used for sphere demapping (e.g., due to the use of the LUT), while the complexity of the QAM inner grid search may depend on an associated modulation order 'M'. Specifically, in this example, the complexity of the sphere demapping may be fixed at O(2x49) while the complexity of the QAM inner grid search may be O(M). The complexity of the QAM inner grid search may therefore be substantially higher than the complexity of sphere demapping for implementations with relatively high modulation orders (e.g., M=4096). $\begin{matrix}{L}_{i = 1 , b}^{\left(1\right)} = \begin{matrix}min \\ {S}_{2} ∈ x \left(49\right)\end{matrix} \left\{\begin{matrix}\left\{{\left|{Y}_{2}-{R}_{2 , 2}{S}_{2}\right|}^{2}\right\} \\ + {\left|{R}_{1 , 1}\right|}^{2} \left\{\begin{matrix}{ϵ}_{Δ}^{2} + {LUT}_{Δ}^{\left(1\right)} \left(b, \left⌈\frac{{\hat{S}}_{1}^{ℜ} + \sqrt{M}}{Δ}\right⌉\right) + {\left|{\hat{S}}_{1}^{ℑ}-\left⌊{\hat{S}}_{1}^{ℑ}\right⌋\right|}^{2} , b ∈ \left[0,q-1\right] \\ {ϵ}_{Δ}^{2} + {LUT}_{Δ}^{\left(1\right)} \left(b, \left⌈\frac{{\hat{S}}_{1}^{ℑ} + \sqrt{M}}{Δ}\right⌉\right) + {\left|{\hat{S}}_{1}^{ℜ}-\left⌊{\hat{S}}_{1}^{ℜ}\right⌋\right|}^{2} , b ∈ \left[q,2q-1\right]\end{matrix}\right\}\end{matrix}\right\} \\ {L}_{i = 1 , b}^{\left(0\right)} = \begin{matrix}min \\ {S}_{2} ∈ x \left(49\right)\end{matrix} \left\{\begin{matrix}\left\{{\left|{Y}_{2}-{R}_{2 , 2}{S}_{2}\right|}^{2}\right\} \\ + {\left|{R}_{1 , 1}\right|}^{2} \left\{\begin{matrix}{ϵ}_{Δ}^{2} + {LUT}_{Δ}^{\left(0\right)} \left(b, \left⌈\frac{{\hat{S}}_{1}^{ℜ} + \sqrt{M}}{Δ}\right⌉\right) + {\left|{\hat{S}}_{1}^{ℑ}-\left⌊{\hat{S}}_{1}^{ℑ}\right⌋\right|}^{2} , b ∈ \left[0,q-1\right] \\ {ϵ}_{Δ}^{2} + {LUT}_{Δ}^{\left(0\right)} \left(b, \left⌈\frac{{\hat{S}}_{1}^{ℑ} + \sqrt{M}}{Δ}\right⌉\right) + {\left|{\hat{S}}_{1}^{ℜ}-\left⌊{\hat{S}}_{1}^{ℜ}\right⌋\right|}^{2} , b ∈ \left[q,2q-1\right]\end{matrix}\right\}\end{matrix}\right\} \\ {L}_{i = 2 , b}^{\left(0\right)} = \begin{matrix}min \\ {S}_{2} ∈ {x}_{b}^{0}\end{matrix} \left(\frac{M}{2}\right) {\left|{R}_{1 , 1}\right|}^{2} {\left|{\hat{S}}_{1}-\left⌊{\hat{S}}_{1}\right⌋\right|}^{2} + {\left|{Y}_{2}-{R}_{2 , 2}{S}_{2}\right|}^{2} \\ {L}_{i = 2 , b}^{\left(1\right)} = \begin{matrix}min \\ {S}_{2} ∈ {x}_{b}^{1}\end{matrix} \left(\frac{M}{2}\right) {\left|{R}_{1 , 1}\right|}^{2} {\left|{\hat{S}}_{1}-\left⌊{\hat{S}}_{1}\right⌋\right|}^{2} + {\left|{Y}_{2}-{R}_{2 , 2}{S}_{2}\right|}^{2} \\ {L}_{i = 1 , b} = {L}_{i = 1 , b}^{\left(1\right)} - {L}_{i = 1 , b}^{\left(0\right)} \\ {L}_{i = 2 , b} = {L}_{i = 2 , b}^{\left(1\right)} - {L}_{i = 2 , b}^{\left(0\right)}\end{matrix}$ Equation 3: demapping using sphere demapping and qam inner grid search

In some implementations, sphere decoding may be used for both streams. For example, the MIMO demapper 208 may apply a permutation to a channel matrix, which may allow sphere demapping to be executed on both streams. In this example, the MIMO demapper 208 may execute an additional QR on a permuted version of the channel matrix "H". This may allow the MIMO demapper 208 to execute sphere demapping on both streams, which can reduce complexity of demapping for high modulation implementations. By applying the permutation, the MIMO demapper 208 can align the bits of the second stream (e.g., Li=2 ) with the LUT used to execute sphere demapping. This alignment enables reuse of the same LUT-based sphere decoding structure for both streams, thereby avoiding a full M-point search on the second stream. As a result of this method, complexity of decoding Li=2 may drop from O(M+2*49+const) to O(4*49+const). In some examples, such as demapping systems with relatively high modulation orders (e.g., M=4096), double sphere demapping can significantly reduce the complexity. As an example, double 49-sphere demapping may be applied according to equation 4. $\begin{matrix}{L}_{i = 1 , b}^{\left(1\right)} = \begin{matrix}min \\ {S}_{2} ∈ x \left(49\right)\end{matrix} \left\{\begin{matrix}\left\{{\left|{Y}_{2}-{R}_{2 , 2}{S}_{2}\right|}^{2}\right\} \\ + {\left|{R}_{1 , 1}\right|}^{2} \left\{\begin{matrix}{ϵ}_{Δ}^{2} + {LUT}_{Δ}^{\left(1\right)} \left(b, \left⌈\frac{{\hat{S}}_{1}^{ℜ} + \sqrt{M}}{Δ}\right⌉\right) + {\left|{\hat{S}}_{1}^{ℑ}-\left⌊{\hat{S}}_{1}^{ℑ}\right⌋\right|}^{2} , b ∈ \left[0,q-1\right] \\ {ϵ}_{Δ}^{2} + {LUT}_{Δ}^{\left(1\right)} \left(b, \left⌈\frac{{\hat{S}}_{1}^{ℑ} + \sqrt{M}}{Δ}\right⌉\right) + {\left|{\hat{S}}_{1}^{ℜ}-\left⌊{\hat{S}}_{1}^{ℜ}\right⌋\right|}^{2} , b ∈ \left[q,2q-1\right]\end{matrix}\right\}\end{matrix}\right\} \\ {L}_{i = 1 , b}^{\left(0\right)} = \begin{matrix}min \\ {S}_{2} ∈ x \left(49\right)\end{matrix} \left\{\begin{matrix}\left\{{\left|{Y}_{2}-{R}_{2 , 2}{S}_{2}\right|}^{2}\right\} \\ + {\left|{R}_{1 , 1}\right|}^{2} \left\{\begin{matrix}{ϵ}_{Δ}^{2} + {LUT}_{Δ}^{\left(0\right)} \left(b, \left⌈\frac{{\hat{S}}_{1}^{ℜ} + \sqrt{M}}{Δ}\right⌉\right) + {\left|{\hat{S}}_{1}^{ℑ}-\left⌊{\hat{S}}_{1}^{ℑ}\right⌋\right|}^{2} , b ∈ \left[0,q-1\right] \\ {ϵ}_{Δ}^{2} + {LUT}_{Δ}^{\left(0\right)} \left(b, \left⌈\frac{{\hat{S}}_{1}^{ℑ} + \sqrt{M}}{Δ}\right⌉\right) + {\left|{\hat{S}}_{1}^{ℜ}-\left⌊{\hat{S}}_{1}^{ℜ}\right⌋\right|}^{2} , b ∈ \left[q,2q-1\right]\end{matrix}\right\}\end{matrix}\right\} \\ {L}_{i = 2 , b}^{\left(0\right)} = \begin{matrix}min \\ {S}_{1} ∈ x \left(49\right)\end{matrix} \left\{\begin{matrix}\left\{{\left|{Y}_{2}-{R}_{2 , 2}{S}_{1}\right|}^{2}\right\} \\ + {\left|{Z}_{1 , 1}\right|}^{2} \left\{\begin{matrix}{ϵ}_{Δ}^{2} + {LUT}_{Δ}^{\left(1\right)} \left(b, \left⌈\frac{{\hat{S}}_{2}^{ℜ} + \sqrt{M}}{Δ}\right⌉\right) + {\left|{\hat{S}}_{1}^{ℑ}-\left⌊{\hat{S}}_{2}^{ℑ}\right⌋\right|}^{2} , b ∈ \left[0,q-1\right] \\ {ϵ}_{Δ}^{2} + {LUT}_{Δ}^{\left(1\right)} \left(b, \left⌈\frac{{\hat{S}}_{2}^{ℑ} + \sqrt{M}}{Δ}\right⌉\right) + {\left|{\hat{S}}_{2}^{ℜ}-\left⌊{\hat{S}}_{2}^{ℜ}\right⌋\right|}^{2} , b ∈ \left[q,2q-1\right]\end{matrix}\right\}\end{matrix}\right\} \\ {L}_{i = 2 , b}^{\left(1\right)} = \begin{matrix}min \\ {S}_{1} ∈ x \left(49\right)\end{matrix} \left\{\begin{matrix}\left\{{\left|{Y}_{2}-{Z}_{2 , 2}{S}_{1}\right|}^{2}\right\} \\ + {\left|{Z}_{1 , 1}\right|}^{2} \left\{\begin{matrix}{ϵ}_{Δ}^{2} + {LUT}_{Δ}^{\left(0\right)} \left(b, \left⌈\frac{{\hat{S}}_{2}^{ℜ} + \sqrt{M}}{Δ}\right⌉\right) + {\left|{\hat{S}}_{1}^{ℑ}-\left⌊{\hat{S}}_{2}^{ℑ}\right⌋\right|}^{2} , b ∈ \left[0,q-1\right] \\ {ϵ}_{Δ}^{2} + {LUT}_{Δ}^{\left(0\right)} \left(b, \left⌈\frac{{\hat{S}}_{2}^{ℑ} + \sqrt{M}}{Δ}\right⌉\right) + {\left|{\hat{S}}_{2}^{ℜ}-\left⌊{\hat{S}}_{2}^{ℜ}\right⌋\right|}^{2} , b ∈ \left[q,2q-1\right]\end{matrix}\right\}\end{matrix}\right\} \\ {L}_{i = 1 , b} = {L}_{i = 1 , b}^{\left(1\right)} - {L}_{i = 1 , b}^{\left(0\right)} \\ {L}_{i = 2 , b} = {L}_{i = 2 , b}^{\left(1\right)} - {L}_{i = 2 , b}^{\left(0\right)}\end{matrix}$ Equation 4: double sphere demapping

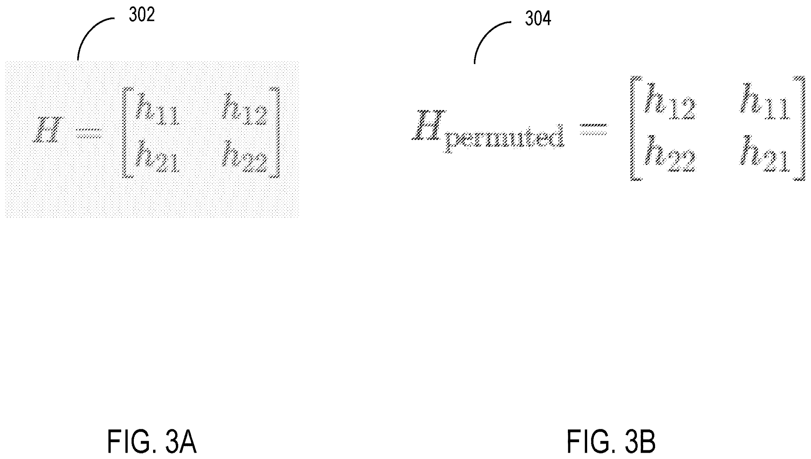

FIGS. 3A-3B are channel matrix permutations, according to one or more embodiments. In an example, channel permutations may be executed by a receiving device (e.g., MIMO demapper 208 of FIG. 2) when demapping a received signal. The receiving device may generate channel matrix 302 based on signals received at a plurality of receivers from a plurality of transmitters. As an example "h11" and "h12" may be associated with (e.g., received by) a first receiver (e.g., antenna 212a of FIG. 2), while "h21" and "h22" may be associated with a second receiver (e.g., antenna 212b of FIG. 2). Similarly, "h11" and "h21" may be associated with (e.g., transmitted by) a first transmitter (e.g., antenna 210a) that transmits a first stream, while "h12" and "h22" may be associated with a second transmitter (e.g., antenna 210b of FIG. 2) that transmits a second stream. In an example, the receiving device may execute QR decomposition on the channel matrix 302. The receiving device can then apply sphere demapping to the output of the QR decomposition to demap the first stream.

In some examples, the receiving device may also demap the second stream using sphere demapping. In these examples, the receiving device may apply a permutation so that the LUT used to demap the first stream can also be used to demap the second stream. For example, the receiving device can permutate the channel matrix 302 to generate the permutated channel matrix 304. The receiving device may execute a column-wise permutation where a first column of the channel matrix 302 is swapped with a second column of the channel matrix 302 to generate the permutated channel matrix 304. The receiving device can then execute QR decomposition on the permutated channel matrix 304. The result of the QR decomposition on the permutated channel matrix 304 can then be demapped using sphere decoding with the same LUT applied to the first stream. This may reduce the complexity of demapping the second stream, particularly for implementations with relatively high modulation orders.

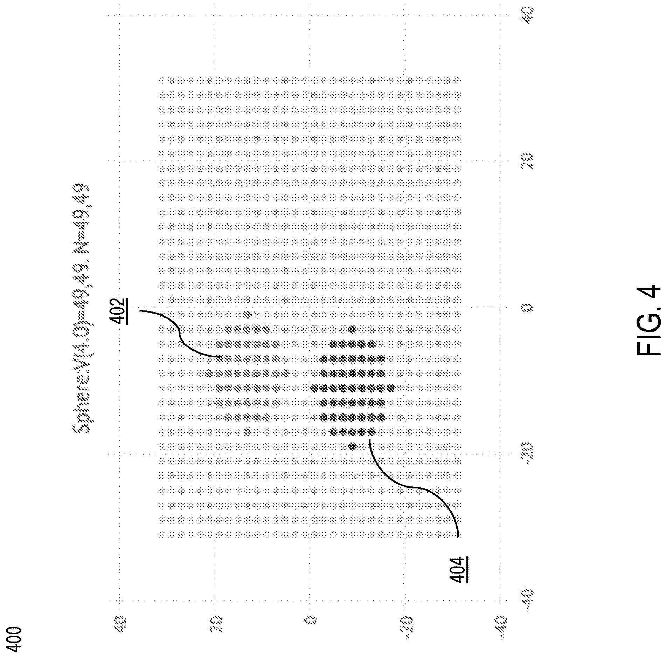

FIG. 4 is a sphere demapping graph 400, according to one or more embodiments. The sphere demapping graph 400 visually represents the distribution of points on a demapping sphere, which is used in the sphere demapping process. The sphere demapping graph 400 may display a 3D spherical space as a 2D representation. The sphere demapping graph 400 includes a first sphere 402 associated with a first stream (e.g., transmitted by antenna 210a of FIG. 2) and a second sphere 404 associated with a second stream (e.g., transmitted by antenna 210b of FIG. 2). The spheres may represent regions in signal space where candidate points are evaluated during the sphere demapping process. In this example, both spheres may have a radius of four points and 49 total points. An additional permutation followed by a QR decomposition may be applied to the second stream to align the second sphere 404 with the first sphere 402. This transformation may ensure that both spheres are aligned in spatial orientation and scale, allowing the same lookup table (LUT) used for demapping the first stream, associated with the first sphere 402, to be reused for the second stream, corresponding to the second sphere 404.

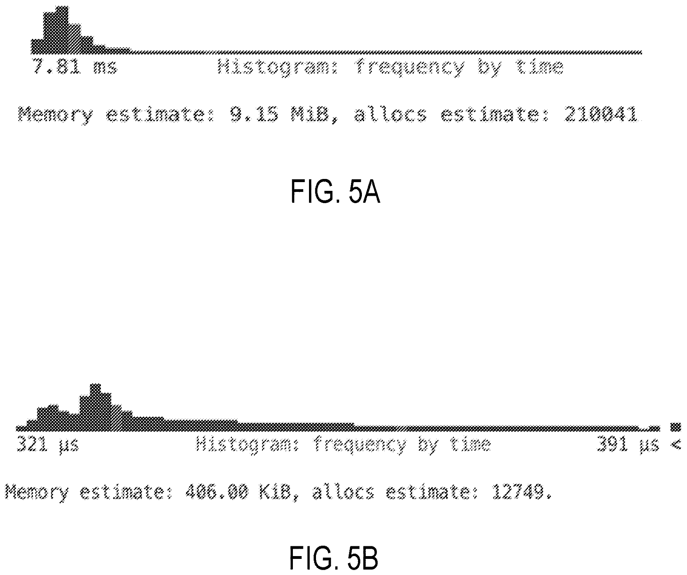

FIGS. 5A-5B are histograms representing computational resources used for sphere demapping, according to one or more embodiments. Demapping can be a computationally expensive process, particularly for relatively high modulation order encoding schemes due to the increased complexity of symbol-to-bit mapping. Specifically, FIGS. 5A-5B indicate memory estimate and allocations estimate for two different demapping methods. Memory estimate may refer to the approximate amount of memory required to execute the demapping computation, including temporary data structures and buffers. Allocations estimate may refer to the number of memory allocation operations performed during the process, which can reflect the complexity and dynamic resource usage of the algorithm. Both values may indicate the computational load and efficiency of the demapping algorithm. For example, higher memory estimates and/or memory estimates may indicate that a demapping algorithm is using more computing resources.

FIG. 5A is a histogram representing computational resources used for a demapping algorithm that includes demapping a first stream (e.g., transmitted by antenna 210a of FIG. 2) using sphere demapping and a second stream (e.g., transmitted by antenna 210b of FIG. 2) using QAM inner grid search. For example, the streams associated with FIG. 5A may be demapped according to equation 3.

FIG. 5B is a histogram representing computation resources used for a demapping algorithm that includes demapping both the first stream and the second stream using sphere demapping. For example, a permutation may be applied to a channel matrix (e.g., as illustrated by FIG. 3), an additional QR decomposition may be applied to the permutated channel matrix, and the second stream may be demapped based on the output of the additional QR decomposition using the same LUT used to demap the first stream. The streams associated with FIG. 5A may be demapped according to equation 4. This may utilize significantly less computational resources than the demapping algorithm associated with FIG. 5A. As illustrated, both the memory estimate and the allocations estimate associated with FIG. 5B are significantly lower than those associated with FIG. 5A. This reduction in resource usage may be attributed to the reuse of the LUT and the structure introduced by the permutation and QR decomposition.

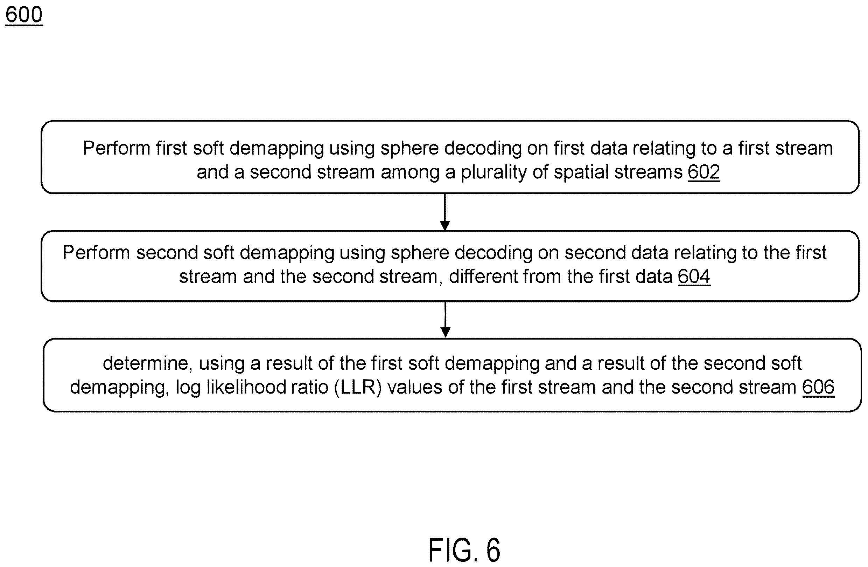

FIG. 6 is a flowchart showing a process for efficient dual sphere soft demapping for multi antenna communication systems, according to one or more embodiments. In some implementations, the process 600 is performed by one or more processors (e.g., main processor 121, and/or the like) or circuitry of a wireless device. In other embodiments, the process 600 includes more, fewer, or different steps than shown in FIG. 6. In an example, the wireless device may include a multiple input multiple output (MIMO) system. For example, the wireless device may include a plurality of receiving antennas that receive data from a plurality of transmitting antennas. The term wireless device may refer to any device that can transmit or receive data. The term MIMO system may refer to any wireless communication system that employs multiple antennas the transmitter and/or receiver.

At step 602, the processors may perform first soft demapping on first data. For example, the wireless device may be configured to receive a plurality of spatial streams from a plurality of transmitting antennas (e.g., antenna 210a and 210b of FIG. 2) associated with a transmitting device. In an example, the wireless device may receive first data relating to a first stream and a second stream of the plurality of spatial streams. The first data may be a channel matrix (e.g., channel matrix 302 of FIG. 3) representing data received by a plurality of receiving antennas from a plurality of transmitting antennas. First stream may refer to data transmitted by a first antenna of the transmitting device (e.g., antenna 210a of FIG. 2) and second stream may refer to data transmitted by a second antenna of the transmitting device (e.g., antenna 210b of FIG. 2). The wireless device may perform soft demapping using sphere decoding to determine log likelihood ratio (LLR) values or other soft bit metrics corresponding to the transmitted bits associated with the first stream. The term spatial stream may refer to a data path, signal layer, antenna stream, or any signal that carries encoded data separately from other streams in a wireless system using multiple antennas (e.g., MIMO system). The term sphere decoding may refer to any method of using a geometric constraint process involving projecting candidate symbol vectors onto a hypersphere centered around an initial estimate to decode received data. The term soft demapping may refer to any method of computing probabilistic metrics from received modulation symbols for use in soft-decision decoding. Soft-decision decoding may be a method of using probabilistic information, such as LLR values, to estimate the most likely transmitted data based on the reliability of received bits. Specifically, soft-decision decoding may involve evaluating multiple possible bit sequences using likelihood metrics and selecting the sequence that maximizes the overall probability, thereby improving error correction performance compared to hard-decision decoding. The term data may refer to any digital representation of information intended for transmission, processing, or storage.

At step 604, the processors may perform second soft demapping using sphere decoding on second data relating to the first stream and the second stream. The second data may be different from the first data. For example, one or more operations may be performed on the first data to generate the second data. In an example, the first data may include a first matrix and the second data may include a second matrix. In this example, the processors may generate the second matrix (e.g., permutated channel matrix 304 of FIG. 3) by permutating the first matrix (e.g., channel matrix 302 of FIG. 3). This may be a column-wise permutation (e.g., as illustrated in FIG. 3) or a row-wise permutation. The term matrix may refer to any array of numerical values arranged in rows and columns. The term permutation may refer to any method of rearranging elements in a set or sequence according to a defined ordering or mapping. As an example, permutating the first matrix may involve switching two columns of the first matrix to generate the second matrix.

In some implementations, the processors may perform QR decomposition. The term QR decomposition may refer to any method of factorizing a matrix into the product of an orthogonal matrix Q and an upper triangular matrix R, or any method of transforming a matrix to facilitate operations performed on the matrix. QR decomposition may be performed before sphere demapping to simplify mapping of data to symbols of the sphere. The QR decomposition may reduce computational complexity and/or numerical stability when searching for a most likely transmitted symbol vector within a constrained search space. In an example, QR decomposition may be executed according to equation 1, as described in FIG. 2.

In some implementations, the first stream and the second stream may have different modulation sizes. Each stream in the plurality of spatial streams may be associated with modulation size. The term modulation size may refer to the number of distinct symbols used in a modulation scheme, which determines the number of bits conveyed per symbol. Higher modulation sizes may allow more bits to be transmitted per symbol, which can increase data rates but also lead to more complex demapping and greater sensitivity to signal quality. In contrast, lower modulation sizes may offer improved robustness to noise and interference but may result in lower spectral efficiency. A MIMO system might include two streams with different modulation sizes to adapt to varying channel conditions, allowing higher-order modulation on stronger channels for increased throughput and lower-order modulation on weaker channels for improved reliability. In some examples, using different modulations sizes for different streams of a MIMO system may be referred to as unequal QAM.

At step 606, the processors may determine log likelihood ratio (LLR) values based on the first soft demapping and the second soft demapping. For example, the processors may compute LLR values by evaluating the probability of each transmitted bit being a 0 or 1 based on the soft-demapped symbol metrics from the first and second streams. The processors may determine LLR values of the first and second streams by applying soft demapping algorithms based on the result (e.g., output) of sphere decoding on the first data and the second data compute bit-level probabilities. These LLR values reflect the confidence of each bit being a 0 or 1, based on the received signal and modulation characteristics of each stream. The term LLR values may refer to soft-decision metrics, probabilistic bit estimates, confidence-weighted decoding inputs, or any set of probabilities that indicate whether a transmitted bit is a 0 or a 1 based on received signal values.

In some implementations, the first and/or second soft demapping may involve a sphere search to determine LLR values. For example, the processors may perform a sphere search on the first stream using the first data to determine the LLR values of the first stream and a separate sphere search on the second stream using the second data to determine LLR values of the second stream. Each sphere search may identify candidate symbol vectors within a constrained radius and evaluate their likelihoods based on the received signal and channel conditions. The resulting symbol metrics can then be used to compute bit-level LLR values, which reflect the probability of each transmitted bit being a 0 or 1. Sphere decoding may refer to the process of executing a sphere search to identify candidate symbol vectors within a bounded radius that minimize the Euclidean distance to the received signal. The term sphere search may refer to any process that identifies candidate symbol vectors within a defined radius of the received signal point in a multidimensional constellation space.

In some implementations, the processors may receive a set of symbols from another wireless device. For example, the wireless device may include a receiver configured to receive encoded data from the other wireless device over a communication channel. In some examples, the processors may receive a set of symbols from the plurality of spatial streams. The processors can then determine first normalized signal values associated with the set of symbols from the first stream based on sphere decoding. Additionally, or alternatively, the processors can determine second normalized signal values associated with the set of symbols from the second stream. As an example, the processors can use sphere decoding to identify the most likely transmitted symbols from each stream by evaluating candidate symbol vectors within a constrained search space and minimizing the distance between the received set of symbols and possible constellation points to generate normalized signal values. Specifically, the processors may search through candidate constellation points using a sphere search to minimize the distance between the received signal and possible transmitted symbol vectors. Additionally, or alternatively, the processors may determine second LLR values of the second stream using the second normalized signal values.

The term receiver may refer to a radio receiver, Wi-Fi receiver, or any circuitry or device that is configured to detect, decode, and process incoming signals or data transmissions. The term communication channel may refer to a cellular link, Wi-Fi link, or any medium that enables the transmission of signals or data wirelessly between a wireless device and another device or network node. The term encoded data may refer to compressed data, encrypted data, formatted data, or any signal that represents information transformed into a specific structure for transmission, storage, or processing. The term symbol may refer to a certain constellation point in a modulation scheme, or any discrete signal unit used to represent information in digital communication systems. The term normalized signal value may refer to any scaled or adjusted signal measurement. The processors may then determine first LLR values of the first stream using the first normalized signal values.

In some implementations, the processors may determine the LLR values using a look-up table (LUT). For example, the processors may generate a LUT that includes one or more slicing errors of the normalized signal values (e.g., the first normalized signal values and the second normalized signal values). The term LUT may refer to a precomputed data array, a memory-based mapping structure, a reference index, or any data structure that maps predefined values to reduce processing complexity in signal processing or decoding operations. The term slicing error may refer to a symbol estimation deviation, demodulation discrepancy, distance based mismatch, or any other mismatch between the normalized signal value and the nearest constellation point. In some examples, at least the first LLR values determined based on the first normalized signal values or the second LLR values determined based on the second normalized signal values can be determined using the LUT. The processors may retrieve precomputed slicing errors from the LUT to evaluate distance-cost functions associated with candidate constellation points. This may decrease computing time and/or increase efficiency involved in generating the LLR values.

The process 600 may decrease computing resources associated with demapping received signals. The processors may apply a QR decomposition to the first data and then execute sphere demapping on the result (e.g., output) of the QR decomposition to generate the first LLR values. The processors may then apply a permutation to the first data to generate the second data and apply an additional QR decomposition to the second data. The result of the additional QR decomposition can then be transformed into the second LLR values using sphere demapping. By applying a permutation followed by QR decomposition, the processors align the second soft demapping with the structure of the first soft demapping, enabling reuse of the LUT originally used to generate the first LLR values. The permutation and additional QR decomposition may allow sphere decoding with the LUT to be used on the second stream, in addition to the first stream, which can greatly reduce the computing resources used to demap a received signal, since sphere demapping with a LUT may be more efficient than alternative decoding methods, such as QAM inner grid search, particularly for high modulation order encoding schemes.

References to "or" may be construed as inclusive so that any terms described using "or" may indicate any of a single, more than one, and all of the described terms. References to at least one of a conjunctive list of terms may be construed as an inclusive OR to indicate any of a single, more than one, and all of the described terms. For example, a reference to "at least one of 'A' and 'B'" can include only 'A', only 'B', as well as both 'A' and 'B'. Such references used in conjunction with "comprising" or other open terminology can include additional items.

It should be noted that certain passages of this disclosure can reference terms such as "first" and "second" in connection with subsets of transmit spatial streams, sounding frames, response, and devices, for purposes of identifying or differentiating one from another or from others. These terms are not intended to merely relate entities (e.g., a first device and a second device) temporally or according to a sequence, although in some cases, these entities can include such a relationship. Nor do these terms limit the number of possible entities (e.g., STAs, APs, beamformers and/or beamformees) that can operate within a system or environment. It should be understood that the systems described above can provide multiple ones of any or each of those components and these components can be provided on either a standalone machine or, in some embodiments, on multiple machines in a distributed system. Further still, bit field positions can be changed and multibit words can be used. In addition, the systems and methods described above can be provided as one or more computer-readable programs or executable instructions embodied on or in one or more articles of manufacture, e.g., a floppy disk, a hard disk, a CD-ROM, a flash memory card, a PROM, a RAM, a ROM, or a magnetic tape. The programs can be implemented in any programming language, such as LISP, PERL, C, C++, C#, or in any byte code language such as JAVA. The software programs or executable instructions can be stored on or in one or more articles of manufacture as object code.

While the foregoing written description of the methods and systems enables one of ordinary skill to make and use embodiments thereof, those of ordinary skill will understand and appreciate the existence of variations, combinations, and equivalents of the specific embodiment, method, and examples herein. The present methods and systems should therefore not be limited by the above described embodiments, methods, and examples, but by all embodiments and methods within the scope and spirit of the disclosure.

## Claims

1. A method for demapping in a wireless device, the method comprising:
performing, by one or more processors, first soft demapping using sphere decoding on first data relating to a first stream and a second stream among a plurality of spatial streams;
performing, by the one or more processors, second soft demapping using sphere decoding on second data relating to the first stream and the second stream, different from the first data; and
determining, by the one or more processors, using a result of the first soft demapping and a result of the second soft demapping, log likelihood ratio, LLR, values of the first stream and the second stream.

2. The method of claim 1, wherein
the first stream and the second stream have different modulation sizes.

3. The method of claim 1 or 2, wherein
the first data includes a first matrix and the second data includes a second matrix, and
the method further comprises generating the second matrix by permuting the first matrix.

4. The method of any one of the claims 1 to 3, wherein
performing the first soft demapping comprises performing a sphere search on the first stream using the first data to determine LLR values of the first stream, and
in performing the second soft demapping, the one or more processors are configured to perform a sphere search on the second stream using the second data to determine LLR values of the second stream.

5. The method of any one of the claims 1 to 4, further comprising:
receiving, by a receiver, encoded data from another wireless device over a communication channel;
receiving a set of symbols from the plurality of spatial streams of the encoded data including the first stream and the second stream;
determining, using the sphere decoding on the first data, first normalized signal values associated with the set of symbols from the first stream; and
determining first LLR values of the first stream using the first normalized signal values.

6. The method of claim 5, further comprising:
generating a look-up table, LUT, including one or more slicing errors of the first normalized signal values,
wherein the first LLR values are determined using the LUT.

7. The method of claim 5 or 6, further comprising:
determining, using the sphere decoding on the second data, second normalized signal values associated with the set of symbols from the second stream; and
determining second LLR values of the second stream using the second normalized signal values.

8. A wireless device comprising:
one or more processors configured to control and/or to perform a method as set forth in any one of the preceding claims 1 to 4.

9. The wireless device of claim 8, further comprising:
a receiver configured to receive encoded data from another wireless device over a communication channel;
wherein the wireless device is configured to control and/or to perform a method as set forth in any one of the preceding claims 5 to 7.

10. A wireless device comprising:
one or more processors configured to:
perform a first QR decomposition on a first matrix relating to a first stream and a second stream among a plurality of spatial streams;
perform a second QR decomposition on a second matrix relating to the first stream and the second stream, different from the first matrix; and
perform, using a result of the first QR decomposition and a result of the second QR decomposition, soft demapping using sphere decoding on the first stream and the second stream.

11. The wireless device of claim 10, wherein
the first stream and the second stream have different modulation sizes.

12. The wireless device of claim 10 or 11, wherein
the one or more processors are configured to generate the second matrix by permuting the first matrix.

13. The wireless device of any one of the claims 10 to 12, wherein
the one or more processors are configured to perform a sphere search on the first stream using the first matrix to determine LLR values of the first stream, and
the one or more processors are configured to perform a sphere search on the second stream using the second matrix to determine LLR values of the second stream.

14. The wireless device of any one of the claims 10 to 13, further comprising:
a receiver configured to receive encoded data from another wireless device over a communication channel,
wherein the one or more processors are configured to:
receive a set of symbols from the plurality of spatial streams of the encoded data including the first stream and the second stream;
determine, using sphere decoding with the first matrix, first normalized signal values associated with the set of symbols from the first stream;
determine first LLR values of the first stream using the first normalized signal values;
determine, using sphere decoding with the second matrix, second normalized signal values associated with the set of symbols from the second stream; and
determine second LLR values of the second stream using the second normalized signal values.

15. The wireless device of claim 14, wherein the one or more processors are further configured to:
generate a look-up table, LUT, including one or more slicing errors of the first normalized signal values and the second normalized signal values,
wherein the first LLR values and the second LLR values are determined using the LUT.
